# EUROPEAN PATENT SPECIFICATION

(11) **EP 2 232 611 B1**
(45) Date of publication and mention of the grant of the patent: **01.11.2017**
(21) Application number: 09701909.5
(22) Date of filing: 13.01.2009
(51) Int. Cl.: H01L 51/54, H01L 51/52

(54) **BARRIER COATED SUBSTRATE AND ELECTRO-OPTICAL DEVICE**
MIT SPERRSCHICHT VERSEHENES SUBSTRAT UND ELEKTROOPTISCHE VORRICHTUNG
SUBSTRAT REVÊTU D'UNE BARRIÈRE ET DISPOSITIF ÉLECTRO-OPTIQUE

(30) Priority: 14.01.2008 GB 0800566; 16.01.2008 GB 0800751
(43) Date of publication of application: 29.09.2010
(73) Proprietor: Merck Patent GmbH, 64293 Darmstadt (DE)
(72) Inventor: KATHIRGAMANATHAN, Poopathy, North Harrow HA2 7NN (GB)
(86) International application number: PCT/GB2009/050022
(87) International publication number: WO 2009/090423

(56) References cited:
- WO-A-01/82390
- WO-A-2007/050334
- WO-A-2008/081178
- US-A- 5 757 126
- US-A1- 2002 140 347
- US-A1- 2003 143 319
- US-A1- 2006 286 402
- SCHMITZ CV ET AL: "Lithium-Quinolate Complexes as Emitter and Interface Materials in Organic Light-Emitting Diodes" CHEMISTRY OF MATERIALS, AMERICAN CHEMICAL SOCIETY, WASHINGTON, US, vol. 12, no. 10, 10 October 2000 (2000-10-10), pages 3012-3019, XP002466152 ISSN: 0897-4756
- OLEKHNOVICH L P ET AL: "Benzoid-quinoid tautomerism of azomethines and their structural analogs. XIII. Effect of the structure of ion pairs formed by aromatic oxyaldehyde imine salts on the absorption and luminescence spectra of the salts" ZHURNAL ORGANICHESKOI KHIMII, MAIK NAUKA, MOSCOW, RU, vol. 9, no. 8, 1 January 1973 (1973-01-01), pages 1724-1730, XP008089996 ISSN: 0514-7492

## Description

### FIELD OF THE INVENTION

The present invention relates to a barrier coated plastics film or sheet and to an opto-electronic device incorporating said film or sheet. Such opto-electronic devices may be used e.g. in the field of flat panel displays and/or in lighting.

### BACKGROUND TO THE INVENTION

The state of the art in OLED technology is reviewed by Hung et al., Materials Science and Engineering, R 39 (2002), 143-222, OLEDS based on glass and silicon are described: OLEDs on plastics are not considered.

US 2001/0052752 (Ghosh et al.) describes a method of encapsulating an organic light emitting diode display device by forming a first encapsulation layer directly on the organic light emitting diode device, and forming a second encapsulation layer on the first encapsulation layer. The first oxide layer is an oxide layer deposited directly on the OLED substrate by atomic layer epitaxy (ALE), atomic layer deposition (ALD) or atomic layer CVD. The second layer is a polymer layer deposited on the oxide layer. The dielectric oxide of the oxide layer preferably comprises Ah03, Si02, Ti02, Zr02, Mgü, Hf02, Ta20₅. aluminum titanium oxide, and tantalum hafnium oxide, more preferably comprises Alzü3 or Siü2, and most preferably comprises Alzü3. The second encapsulation polymer layer of this device preferably comprises a parylene, and in particular, parylene N, parylene C, or parylene D, and more preferably comprises parylene C. The method is applicable to the encapsulation of top-emitting OLEDs. A highly conformal oxide layer can be deposited without any energetic particles impinging the OLED surface, a low-temperature ALD deposition process (approximately 100-120°C) providing a conformal coating of an oxide such as Ah03 or Si02. This oxide layer then forms a primary moisture barrier layer which is protected e.g. from attack by basic chemicals by means of a layer deposited at or below room temperature of highly chemically resistant polymer material. Preferred polymers for this layer are the parylenes whose chemical inertness and the ease of deposition of parylenes are known. Parylenes form highly conformal coatings that help in covering any stray particles and pinholes. Parylene coating is a room temperature deposition process that does not require any ultraviolet curing. The three standard parylenes are parylene N, parylene C and parylene D described below.

US-A-6926572 (Park et al.) discloses ALD deposition of a passivation layer on an OLED by ALD at a substrate temperature of 20-220°C, the layer being of Ah0₃, Znü, Ti0₂, Ta₂0₅, Zr0₂. HfD₂, Si0₂, Si₃N₄, AlN and AlON and in the case of a plasma precursor deposition being at room temperature. An organic insulating film may be fabricated by the method of TCVDPF (thermal chemical-vapor-deposition polymer) starting e.g. from triethyl aluminium. Again organic layers of parylene are disclosed, see also US-A-7067439 (Metzner et al.*)* and 2003/0129298 (Tera et al.).

US-A-2004/0046165 (Hunze et al.) discloses a plasma encapsulation for electronic and microelectronic components such as OLEDs. However, a conventional standard plasma coating process is not used; instead, an especially gentle plasma coating process which does not cause any damage to sensitive components such as an OLED is used, such as the pulsed method or the "remote" or "after glow method." It is explained that chemical compatibility between the materials used for encapsulation and the component to be protected must be ensured and also because of the limited thermal resistance of the functional organic materials used in OLEDs is limited, encapsulation should be performed at the lowest possible temperatures e.g. not more than about 100°C. Plasma supported CVD can be carried out at the desired low temperatures, and is stated to give flexible pinhole-free coatings. The precursor mixture may include sources of adhesion-promoting heteroatoms.

US-A-2003/0143319 (Park et al.) a method of forming a passivation film in a flat panel display device, comprising the steps of:
forming the flat panel display device on a substrate;
bringing the flat panel display device into a chamber in order to form the passivation film; injecting precursors containing constituent elements of the passivation film into the chamber; and
forming the passivation film of an inorganic insulating material at a temperature of 20 to 220°C through a surface chemical reaction between the precursors by an atomic layer deposition method and
a flat panel display device having a passivation film comprising a flat panel display device formed on a substrate with a metal film at its top layer; and the passivation film made of an inorganic insulating film on the metal film, wherein the inorganic insulating film includes an aluminium oxide film, aluminium nitride or silicon nitride, which is formed at a temperature of 20 to 220°C through a surface chemical reaction between precursors
containing constituent elements of the inorganic insulating film by means of an atomic layer deposition method.

US-A-5757126 (Harvey et al.) describes a method of passivating organic devices positioned on a supporting transparent plastic substrate including the steps of overcoating the plastic substrate with a multi-layer overcoating. The polymer film layer used in overcoating the plastic actas as means of improving the barrier properties of the multi-layer overcoating and the dielectric material acts as a physical barrier to atmospheric elements.

US-A-2002/0140347 (Michael S. Weaver) describes a covered substrate which comprises a flexible substrate layer and a plurality of cooperative barrier layers disposed on the substrate layer and an OLED structure comprising such a covered substrate.

WO 01/82390 (Emagin Corp.) is directed to an OLED display device including an encapsulation assembly including at least two layers, one of which is a dielectric oxide layer directly in contact with at least part of a substrate, and the other of which is preferably a polymer layer.

### SUMMARY OF THE INVENTION

Embodiments of the invention provide a plastics substrate for an electro-optical device, said substrate having a layer or stacked layers on a surface thereof providing a moisture and/or oxygen barrier according to claim 1.

The substrate may provide a cathode in an OLED or other electro-optical device.

In a further aspect the invention provides a method for forming an OLED, according to claim 9, which comprises: providing a plastics substrate; depositing one or more metallic or
inorganic barrier layers on the substrate by means of CVD, plasma-assisted CVD, atomic layer epitaxy (ALE), atomic layer deposition (ALD) or atomic layer CVD; depositing one or more organic barrier layers on the metallic or inorganic layers; and depositing OLED-forming layers on the barrier layers.

### DESCRIPTION OF PREFERRED EMBODIMENTS

### Cell structure

The OLEDs of the invention are useful *inter alia* in flat panel displays and typically comprise an anode and a cathode between which is sandwiched a multiplicity of thin layers including an electroluminescent layer, electron injection and/or transport layer(s), hole injection and/or transport layer(s) and optionally ancillary layers. The layers are typically built up by successive vacuum vapour deposition operations, although it may be convenient to form one or more of the layers e.g. the hole injection and hole transport layers by other methods e.g. spin coating or ink jet printing.

It is a feature of the invention that the cathode is supported by a plastics material which may be transparent. A suitable material for use as such a substrate consists of or comprises polyethylene naphthalate (PEN) which is preferred, polyethylene terephthalate (PET), polybutylene terephthalate (PBT) or other polyester, polyether sulfone (PES), polyether ether ketone (PEEK) or polyimide in sheet or film form. This PEN has good mechanical properties combined with low gas permeability, in particular low permeability to water vapour. Such a substrate is formed on its intended blind or exposed face or on both of them with a barrier layer or with a plurality of stacked barrier layers. Film substrates may have thicknesses of 10-250µm, sometimes 100-200µm, e.g. 125 or 175µm.

The diffusion barrier layer or layers or at least some of the layers of diffusion barrier material may be of a parylene which is a vacuum-depositable plastics material. There are three common materials of this type, parylene N which is poly-*p*-xylene, parylene C which is poly(2-chloro-1,4-dimethylbenzene) and is of particularly low gas permeability and parylene D which is poly(1,4-dichloro-2,5-dimethylbenzene). The polymers may be formed from the corresponding di-*p*-xylylenes by vaporization *in vacuo,* pyrolysis e.g. at about 650° *in vacuo* e.g in a tube furnace and *in vacuo* polymerization on a substrate at ambient temperatures. They can provide uniform and pinhole-free coatings. Film thicknesses of up to 1 µm e.g. 10-200 nm e.g. about 100 nm may be used. The combination of polyester film or sheet e.g. polyethylene naphthalate and parylene N, C or D as barrier layer has not been disclosed.

The diffusion barrier layer or at least one stacked layer may be of a fluorinated polymer e.g.CFₓ.

The diffusion barrier layer or layers or at least some of the layers of diffusion barrier material may be of metal or alloy film e.g. a film of Al, Ti, Zr, Hf, V, Nb, Ta, Pt, Au, Ag or In or a film of Al/Ag, Al/Mg, Al/Li, Si/Al, In/Ga, In/Zn, Al/Cu, Al/Ti, Al/Y, Ta/Al, Ta/Si, W/Si, W/Ti, Zn/Al etc. Deposition of the metal film on the plastics sheet or film e.g. PEN which should be maintained below Tg e.g. about or below 120°C may be by thermal evaporation, sputtering, CVD or plasma-enhanced CVD using as starting material e.g. a metal carbonyl or organometallic compound.

The diffusion barrier layer or layers or at least some of the layers of diffusion barrier material may be of metal oxide e.g. Al₂O₃, CaO, amorphous TiOₓ, TiO₂, Zr₂O₅, Hf₂O₅, Ta₂O₅ or Nb₂O₅ or SiO₂ or SiOₓ or an oxide of scandium, yttrium, lanthanum, vanadium, molybdenum , tungsten, silicon, zinc and indium. It may also be a mixed metal oxide e.g. aluminium titanium oxide or tantalum hafnium oxide. Again such layers may be deposited *in vacuo* e.g. by chemical vapour deposition. CVD may be carried out by reacting a metal alkyl or alkoxide e.g. a metal ethoxide with ozone under relatively benign conditions e.g. by reacting trimethylaluminium or tantalum or niobium pentaethoxide with oxygen or ozone. Alternatively the metal oxide may be formed by depositing metal on the plastics film or sheet and then converting the metal to its oxide. The diffusion barrier layer layers may be deposited by microwave plasma-assisted CVD, plasma-enhanced CVD or remote plasma-enhanced CVD in which the plastics substrate is not directly in the plasma discharge region and will normally be at low pressures or under UHV. It is an advantage that it is the plastics substrate and not the OLED layers that are presented during CVD, the layers of OLED material being deposited later so that they only see the deposited metal or oxide or stacked organic layer and do not see the conditions required for the deposition.

The diffusion barrier layer or layers or some of them may also be a metal or metalloid nitride or boride e.g. SiN or BN formed e.g. by reacting a volatile silicon or boron compound with ammonia.

Where the barrier layer is of a metal or inorganic metal compound, the layer thickness may e.g. be up to 1 µm e.g. 10-70 nm e.g. about 50 nm.

Metals and metal oxides may also be deposited on the plastics film or sheet e.g. PEN by spraying, ink-jet printing, dip coating, spin coating, sol-gel deposition or other solution process.

At least one metal or inorganic diffusion barrier layer may be deposited by atomic layer deposition (ALD) or the like. The techniques disclosed in US 2001/0052752 may be employed, the barrier layer or stacked barrier layers being formed on one or both faces of the plastics substrate followed by deposition of the ALD layers and encapsulation to protect the cell. Plasma assisted ALD may be employed, low substrate temperatures being an advantage for plastics substrates and sheet or film substrates being less vulnerable to plasma than the layer materials of an OLED.

Combinations of stacked barrier layers may be employed e.g. metal oxide(s)/organic(s), metal oxide (s)/organic(s)/metal oxide (s), organic(s)/metal oxide(s)/organic(s) and other combinations thereof, metal oxide/metal, metal (alloys) oxide/metal (alloys)/organic(s), metal oxide/organic(s)/metal (alloys). For example, there may be employed Al₂O₃ deposited by CVD or ALD in combination with a polymer layer and optionally a SiN layer. The structure may have two or more layers and in the case e.g. of a two-layer structure a metal oxide e.g. aluminium oxide may be deposited as a layer on the plastics film or sheet followed by e.g. a parylene. The stack may, for example, comprise a multiplicity of inorganic layers deposited by ALD followed by one or more layers of parylene or other plastics material. In addition to formation of diffusion layers or layer stacks on one or both faces of the substrate, the OLED may be encapsulated using ALD as described e.g. in US-A-2001/0052752.

A typical device comprises a transparent substrate on which are successively formed an anode layer, a hole injector (buffer) layer, a hole transport layer, an electroluminescent layer, an electron transport layer, an electron injection layer and a cathode layer which may in turn be laminated to a second transparent substrate. A further possibility is an inverted OLED in which a cathode of aluminium or aluminium alloyed with a low work function metal carries successively an electron injection layer, an
electron transport layer, an electroluminescent layer, a hole transport layer, a hole injection layer and an ITO or other transparent conductive anode, emission of light being through the anode. If desired a hole blocking layer may be inserted e.g. between the electroluminescent layer and the electron transport layer. There may also be incorporated a layer of a reflectivity influencing material e.g. copper quinolate, vanadyl oxyquinolate or vanadyl tetraphenoxy phthalocyanine e.g. as described in WO 2007/052083 (Kathirgamanathan et al.*).*

OLEDs of the invention include small molecule OLEDs, polymer light emitting diodes (p-OLEDs), OLEDs that emit light by fluorescence, OLEDs that emit light by phosphorescence (PHOLEDs) and OLEDs that emit light by ion fluorescence (rare earth complexes) and include single-colour or multi-colour active or passive matrix displays.

The front and/or rear films or sheets of an OLED may be provided on front and/or rear surfaces with microlenses or microlens arrays e.g. an array of microlenses of organic polymer (e.g. polymethyl methacrylate) printed onto an OLED substrate or plate e.g. a substrate or plate to form a front plate of an OLED, see e.g. Sun et al., Organic light emitting devices with enhanced outcoupling via microlenses fabricated by imprint lithography, J Appl. Phys. 100, 073106 (2006) and WO 2003/007663 (Moler et al.*,* Princeton). Prismatic and lenticular films are available from Microsharp Corporation Limited of Watchfield, Oxfordshire and microlens and prismatic sheeting is available from 3M Corporation.

There may be employed conducting substrates: ITO/plastics transparent metal coatings/plastics, InZnO/plastics. Conducting polymer coated plastics may be used, for example, as anodes.

The OLEDs may be of the active matrix type or of the passive matrix type. A representative active matrix OLED array is described in US-A-5929474 (Huang, Motorola). That specification describes an active matrix organic light emitting device array comprising: (a) a semiconductor substrate having an array area defined thereon; (b) a plurality of field effect transistors, each including first and second current carrying terminals and a control terminal, formed in the array area on the semiconductor substrate in rows and columns, each of the rows including a row bus coupled to the first current carrying terminal of each field effect transistor in the row, and each of the columns including a column bus coupled to the control terminal of each field effect transistor in the column; (c) a planarizing layer of insulating material positioned over the plurality of field effect transistors in the array area and defining a substantially planar surface; (d) a plurality of contact pads formed on the planar surface of the planarizing layer in the array area in rows and columns, each contact pad of the plurality of contact pads associated with one field effect transistor of the plurality of field effect transistors and coupled to the second current carrying terminal of the associated field effect transistor by a conductor formed through the planar layer; (e) a plurality of layers of organic material sequentially formed in overlying relationship on the contact pads in the array area so as to define an organic light emitting device on each contact pad with each contact pad operating as a first terminal of an overlying organic light emitting device; and (f) electrical and light conducting material positioned in overlying relationship over the layers of organic material in the array area and operating as a common second terminal of the organic light emitting devices. Further references describing active matrix devices are EP-A-0717446 (Tang et al.,Kodak) and WO 99/65012 (Knapp et al.*,* Philips). Choice of active or passive matrix driving may affect the selection of electrode materials, but need not fundamentally affect the choice of materials for the layers between the electrodes.

### Anode

In some embodiments the anode may be formed from a plastics substrate coated with one or more barrier layer materials as indicated above and then with electrode material which may be tin oxide or indium tin oxide (ITO), antimony tin oxide or indium zinc oxide, aluminium zinc oxide, aluminium tin oxide or Pt or Au or another high work function metal. As regards substrates, rigid or flexible transparent plastics materials e.g. sheet or film may be used, preferably materials which are dimensionally stable, impermeable to water (including water vapour) and of relatively high Tg. PEN is a preferred material, other materials that may be used including PES, PEEK and PET. The barrier layer may, for example be a combination of metal or inorganic layers and organic layers, e.g. a stack of a metal oxide and a parylene which may be surface treated e.g. by corona discharge or by plasma treatment to improve adhesion or may be treated with an adhesion promoter layer which is a silyl compound, a phthalocyanine e.g. CuPC or a porphyrin or a silylated phthalocyanine.

### Hole injection materials

A single layer may be provided between the anode and the electroluminescent material, but in many embodiments there are at least two layers one of which is a hole injection layer (buffer layer) and the other of which is a hole transport layer, the two layer structure offering in some embodiments improved stability and device life (see US-A-4720432 (VanSlyke et al.*,* Kodak). The hole injection layer may serve to improve the film formation properties of subsequent organic layers and to facilitate the injection of holes into the hole transport layer.

Suitable materials for the hole injection layer which may be of thickness e.g. 0.1-200 nm depending on material and cell type include hole-injecting porphyrinic compounds - see US-A-4356429 (Tang, Eastman Kodak) e.g. zinc phthalocyanine copper phthalocyanine and ZnTpTP, whose formula is set out below:

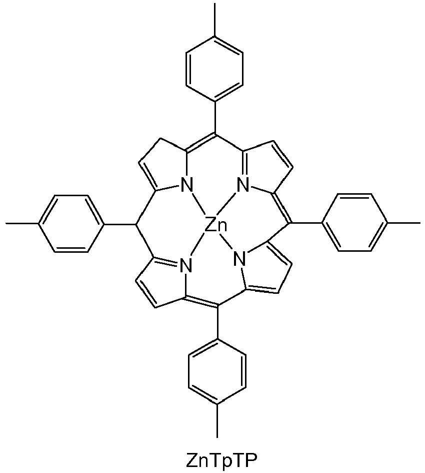

Particularly good device efficiencies, turn/on voltages and/or lifetimes may be obtained where the hole injection layer is ZnTpTP both when the host material for the electroluminescent layer is an organic complex e.g. a metal quinolate such as aluminium quinolate and when the host material is an organic small molecule material. A further material that may be used is hexacyanohexaazatriphenylene (CHATP) of structure:

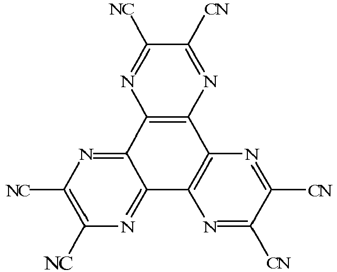

The hole injection layer may also be a fluorocarbon-based conductive polymer formed by plasma polymerization of a fluorocarbon gas - see US-A-6208075 (Hung et al; Eastman Kodak), a triarylamine polymer - see EP-A-0891121 (Inoue et al.*,* TDK Corporation) or a phenylenediamine derivative - see EP-A- 1029909 (Kawamura et al.*,* Idemitsu) or the materials described in US-A-6436559 (Ueno, Canon) and 6720573 (Se-Hwan, LG Chemical Co., Ltd.). It may also be a solution-processable hole injecting polymer e.g. PEDOT/PSS (poly-3,4-ethylenedioxythiophene doped with poly(styrenesulfonate) or a block copolymers of PEDOT and a flexible polymer such as a polyether, polysiloxane, polyester, or polyacrylate. Methods of applying such materials include spin coating, printing through a mask and ink jet printing

### Hole-transport materials

Hole transport layers which may be used are in some embodiments preferably of thickness 20 to 200 nm.

One class of hole transport materials comprises polymeric materials that may be deposited as a layer by means of spin coating or ink jet printing. Such polymeric hole-transporting materials include poly(*N*-vinylcarbazole) (PVK), polythiophenes, polypyrrole, and polyaniline. Other hole transporting materials are conjugated polymers e.g. poly (p-phenylenevinylene) (PPV) and copolymers including PPV. Other preferred polymers are: poly(2,5 dialkoxyphenylene vinylenes e.g. poly (2-methoxy-5-(2-methoxypentyloxy-1,4-phenylene vinylene), poly(2-methoxypentyloxy)-1,4-phenylenevinylene), poly(2-methoxy-5-(2-dodecyloxy-1,4-phenylenevinylene) and other poly(2,5 dialkoxyphenylenevinylenes) with at least one of the alkoxy groups being a long chain solubilising alkoxy group; polyfluorenes and oligofluorenes; polyphenylenes and oligophenylenes; polyanthracenes and oligoanthracenes; and polythiophenes and oligothiophenes.

A further class of hole transport materials comprises sublimable small molecules. For example, aromatic tertiary amines provide a class of preferred hole-transport materials, e.g. aromatic tertiary amines including at least two aromatic tertiary amine moieties (e.g. those based on biphenyl diamine or of a "starburst" configuration), of which the following are representative:

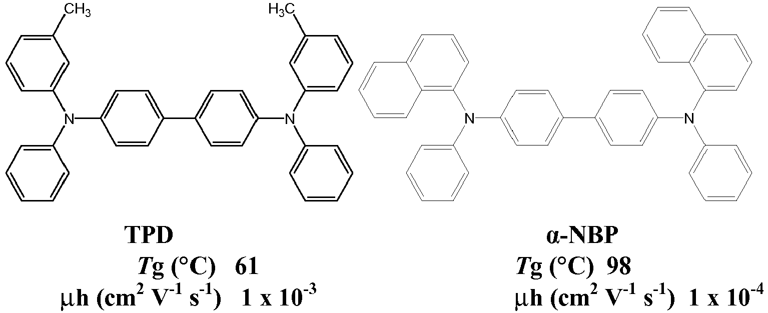

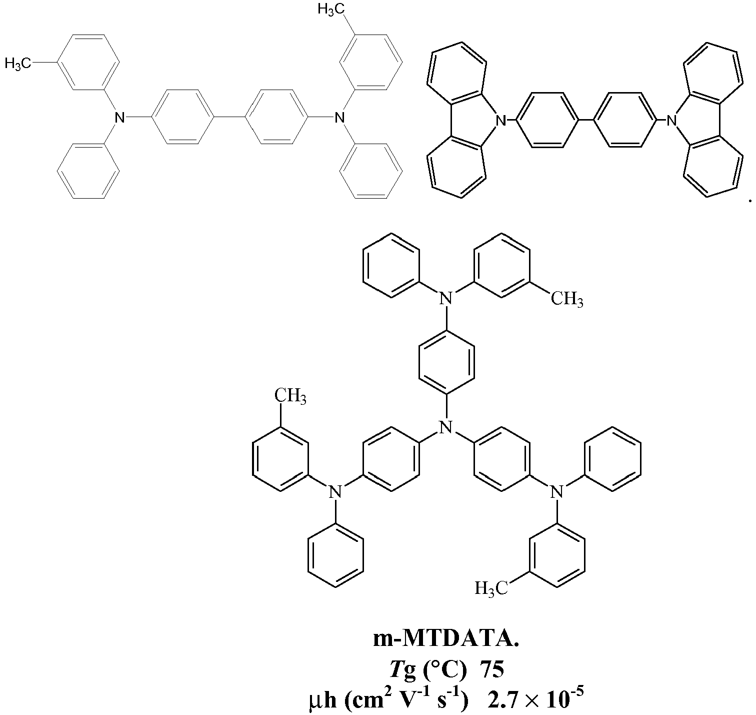

A further possible material is 4,4',4"-tris(carbazolyl)-triphenylamine (TCTA) which is a hole transport material with a wider band gap than α-NBP and which can in some embodiments assist in confining excitation to the emissive layer.

It further includes spiro-linked molecules which are aromatic amines e.g. spiro-TAD (2,2',7,7'-tetrakis-(diphenylamino)-spiro-9,9'-bifluorene).

A further class of small molecule hole transport materials is disclosed in WO 2006/061594 (Kathirgamanathan et al) and is based on diamino dianthracenes. Typical compounds include:
9-(10-(N-(naphthalen-1-yl)-N-phenylamino)anthracen-9-yl)-N-(naphthalen-1-yl)-N-phenylanthracen-10-amine;
9-(10-(N-biphenyl-N-2-*m*-tolylamino)anthracen-9-yl)-N-biphenyl-N-2-*m-*tolylamino-anthracen-10-amine; and
9-(10-(N-phenyl-N-m-tolylamino)anthracen-9-yl)-N-phenyl-N-m-tolylanthracen-10-amine.

The hole transport layer may be p-doped e.g. with a an acceptor-type organic molecule e.g. tetrafluorotetracyanoquinodimethane (F₄-TCNQ) e.g. it may be starburst m-MTDATA doped with F₄-TCNQ.

### Electroluminescent materials

In principle any electroluminescent material may be used, including molecular solids which may be fluorescent dyes e.g. perylene dyes, metal complexes e.g. Alq₃, so-called "blue" aluminium quinolates of the type Alq₂L where q represents a quinolate and L represents a mono-anionic aryloxy ligand e.g. bis(2-methyl-8-quinolinolato)(4-phenyl-phenolato)Al(III), Ir(III)L₃, rare earth chelates e.g. Tb(III) complexes, dendrimers and oligomers e.g. sexithiophene, or polymeric emissive materials. The electroluminescent layer may comprise as luminescent material a metal quinolate, iridium, ruthenium, osmium, rhodium, iridium, palladium or platinum complex, a boron complex or a rare earth complex

One preferred class of electroluminescent materials comprises host materials doped with one or more dyes or complexes which may be fluorescent, phosphorescent or ion-phosphorescent (rare earth). The term "electroluminescent device" includes electrophosphorescent devices.

Preferably the host is doped with a minor amount of a fluorescent material as a dopant, preferably in an amount of 0.01 to 25% by weight of the doped mixture. As discussed in US-A-4769292 (Tang et al.*,* Kodak), the presence of the fluorescent material permits a choice from amongst a wide latitude of wavelengths of light emission. In particular, as disclosed in US-A-4769292 by blending with the organo metallic complex a minor amount of a fluorescent material capable of emitting light in response to hole-electron recombination, the hue of the light emitted from the luminescent zone, can be modified. In theory, if a host material and a fluorescent material could be found for blending which have exactly the same affinity for hole-electron recombination, each material should emit light upon injection of holes and electrons in the luminescent zone. The perceived hue of light emission would be the visual integration of both emissions. However, since imposing such a balance of host material and fluorescent materials is limiting, it is preferred to choose the fluorescent material so that it provides the favoured sites for light emission. When only a small proportion of fluorescent material providing favoured sites for light emission is present, peak intensity wavelength emissions typical of the host material can be entirely eliminated in favour of a new peak intensity wavelength emission attributable to the fluorescent material.

While the minimum proportion of fluorescent material sufficient to achieve this effect varies, in no instance is it necessary to employ more than about 10 mole percent fluorescent material, based of host material and seldom is it necessary to employ more than 1 mole percent of the fluorescent material. On the other hand, limiting the fluorescent material present to extremely small amounts, typically less than about 10⁻³ mole percent, based on the host material, can result in retaining emission at wavelengths characteristic of the host material. Thus, by choosing the proportion of a fluorescent material capable of providing favoured sites for light emission, either a full or partial shifting of emission wavelengths can be realized. This allows the spectral emissions of the EL devices to be selected and balanced to suit the application to be served. In the case of fluorescent dyes, typical amounts are 0.01 to 5 wt%, for example 2-3 wt%. In the case of phosphorescent dyes typical amounts are 0.1 to 15 wt%. In the case of ion phosphorescent materials typical amounts are 0.01-25 wt% or up to 100 wt%.

Choosing fluorescent materials capable of providing favoured sites for light emission, necessarily involves relating the properties of the fluorescent material to those of the host material. The host can be viewed as a collector for injected holes and electrons with the fluorescent material providing the molecular sites for light emission. One important relationship for choosing a fluorescent material capable of modifying the hue of light emission when present in the host is a comparison of the reduction potentials of the two materials. The fluorescent materials demonstrated to shift the wavelength of light emission have exhibited a less negative reduction potential than that of the host. Reduction potentials, measured in electron volts, have been widely reported in the literature along with varied techniques for their measurement. Since it is a comparison of reduction potentials rather than their absolute values which is desired, it is apparent that any accepted technique for reduction potential measurement can be employed, provided both the fluorescent and host reduction potentials are similarly measured. A preferred oxidation and reduction potential measurement techniques is reported by R. J. Cox, Photographic Sensitivity, Academic Press, 1973, Chapter 15.

A second important relationship for choosing a fluorescent material capable of modifying the hue of light emission when present in the host is a comparison of the band-gap potentials of the two materials. The fluorescent materials demonstrated to shift the wavelength of light emission have exhibited a lower band gap potential than that of the host. The band gap potential of a molecule is taken as the potential difference in electron volts (eV) separating its ground state and first singlet state. Band gap potentials and techniques for their measurement have been widely reported in the literature. The band gap potentials herein reported are those measured in electron volts (eV) at an absorption wavelength which is bathochromic to the absorption peak and of a magnitude one tenth that of the magnitude of the absorption peak. Since it is a comparison of band gap potentials rather than their absolute values which is desired, it is apparent that any accepted technique for band gap measurement can be employed, provided both the fluorescent and host band gaps are similarly measured. One illustrative measurement technique is disclosed by F. Gutman and L. E. Lyons, Organic Semiconductors, Wiley, 1967, Chapter 5.

With host materials which are themselves capable of emitting light in the absence of the fluorescent material, it has been observed that suppression of light emission at the wavelengths of emission characteristics of the host alone and enhancement of emission at wavelengths characteristic of the fluorescent material occurs when spectral coupling of the host and fluorescent material is achieved. By "spectral coupling" it is meant that an overlap exists between the wavelengths of emission characteristic of the host alone and the wavelengths of light absorption of the fluorescent material in the absence of the host. Optimal spectral coupling occurs when the emission wavelength of the host is within ±25m of the maximum absorption of the fluorescent material alone. In practice advantageous spectral coupling can occur with peak emission and absorption wavelengths differing by up to 100 nm or more, depending on the width of the peaks and their hypsochromic and bathochromic slopes. Where less than optimum spectral coupling between the host and fluorescent materials is contemplated, a bathochromic as compared to a hypsochromic displacement of the fluorescent material produces more efficient results.

Useful fluorescent materials are those capable of being blended with the host and fabricated into thin films satisfying the thickness ranges described above forming the luminescent zones of the EL devices of this invention. While crystalline organometallic complexes do not lend themselves to thin film formation, the limited amounts of fluorescent materials present in the host permit the use of fluorescent materials which are alone incapable of thin film formation. Preferred fluorescent materials are those which form a common phase with the host. Fluorescent dyes constitute a preferred class of fluorescent materials, since dyes lend themselves to molecular level distribution in the host. Although any convenient technique for dispersing the fluorescent dyes in the host can be used preferred fluorescent dyes are those which can be vacuum vapour deposited along with the host materials.

One class of host materials comprises metal complexes e.g. metal quinolates such as lithium quinolate (see EP-A-1144543 Kathirgamanathan et al., aluminum quinolate, titanium quinolate, zirconium quinolate or hafnium quinolate which may be doped with fluorescent materials or dyes as disclosed in patent application WO 2004/058913.

In the case of quinolates e.g. aluminium quinolate:
(a) the compounds below, for example, can serve as red dopants: 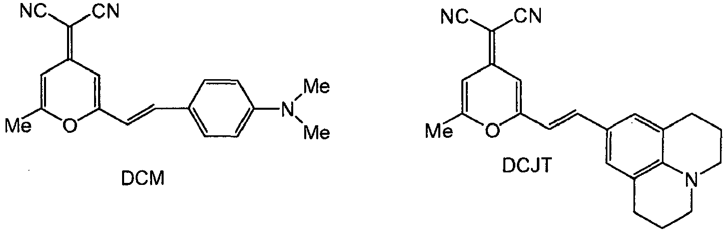 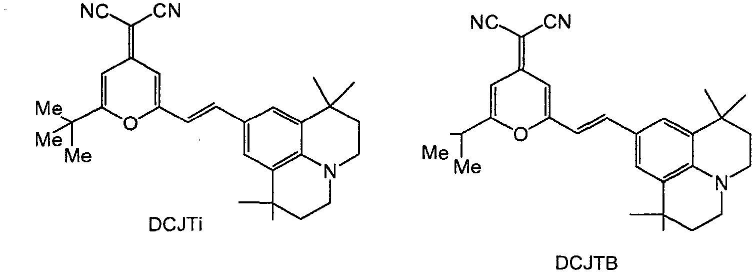
(b) the compounds below, for example can serve as green dopants: 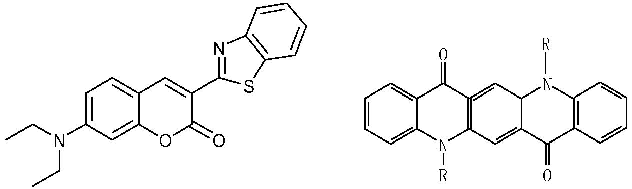 wherein R is C₁ - C₄ alkyl, monocyclic aryl, bicycic aryl, monocyclic heteroaryl, bicyclic heteroaryl, aralkyl or thienyl, preferably phenyl; and
(c) for biphenyloxy aluminium bis-quinolate (BAlQ₂) or aluminium quinolate the compounds perylene and 9-(10-(N-(naphthalen-8-yl)-N-phenylamino)anthracen-9-yl)-N-(naphthalen-8-yl)-N-phenylanthracen-10-amine can serve as a blue dopants.

Another preferred class of hosts is small molecules incorporating conjugated aromatic systems with e.g. 4-10 aryl or heteroaryl rings which may bear substituents e.g. alkyl (especially methyl), alkoxy and fluoro and which may also be doped with fluorescent materials or dyes.

An example of a system of the above kind is a blue-emitting material based on the following compound (Compound H) as host 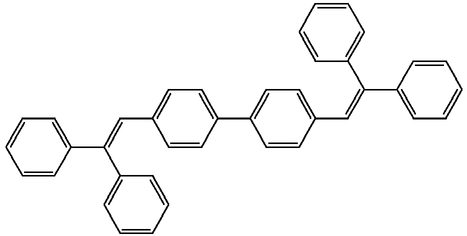 and perylene or 9-(10-(N-(naphthalen-8-yl)-N-phenylamino)anthracen-9-yl)-N-(naphthalen-8-yl)-N-phenylanthracen-10-amine as dopant. Further examples of host materials which are small aromatic molecules are shown below:

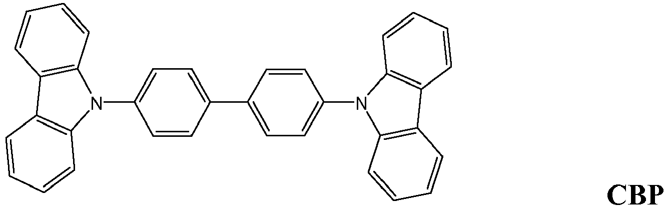

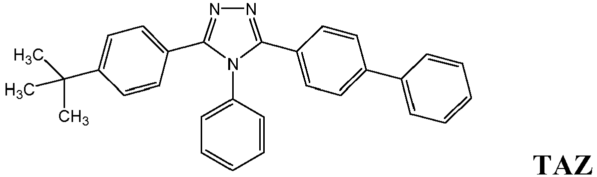

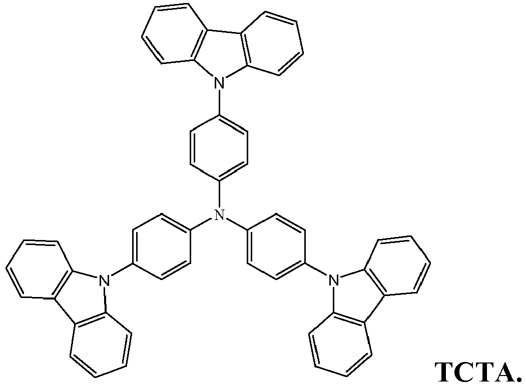

2,9-Bis(2-thiophen-2-yl-vinyl)-[1,10] phenanthroline may, as explained above, may be used as host in the electroluminescent layer or may be present on its own.

Blue-emitting materials may be based on an organic host (e.g. a conjugated aromatic compound as indicated above) and diarylamine anthracene compounds disclosed in WO 2006/090098 (Kathirgamanathan et al.) as dopants. For example, CBP may be doped with blue-emitting substituted anthracenes inter *alia*
9,10-bis(-4-methylbenzyl)-anthracene,
9,10-bis-(2,4-dimethylbenzyl)-anthracene,
9,10-bis-(2,5-dimethylbenzyl)-anthracene,
1,4-bis-(2,3,5,6-tetramethylbenzyl)-anthracene,
9,10-bis-(4-methoxybenzyl)-anthracene,
9,10-bis-(9H-fluoren-9-yl)-anthracene,
2,6-di-t-butylanthracene,
2,6-di-t-butyl-9,10-bis-(2,5-dimethylbenzyl)-anthracene,
2,6-di-t-butyl-9,10-bis-(naphthalene-1-ylmethyl)-anthracene.

Further blue-emitting materials may employ TCTA as host and it may be doped with the blue phosphorescent materials set out below, see WO 2005/080526 (Kathirgamanathan et al.):

### Blue Phosphorescent Materials

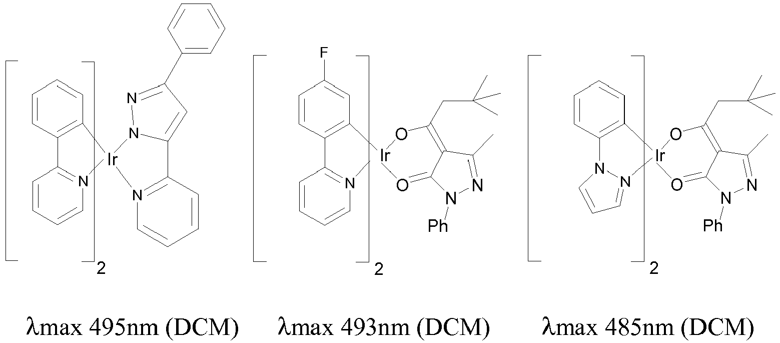

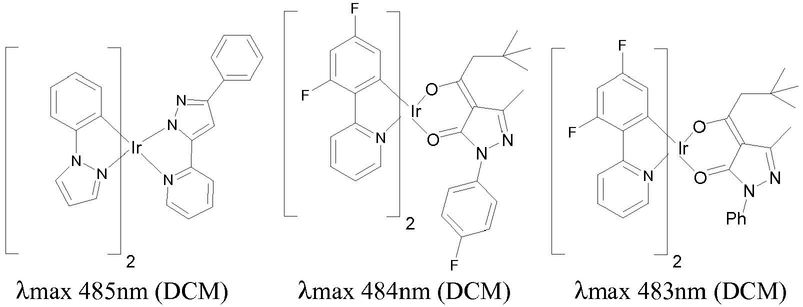

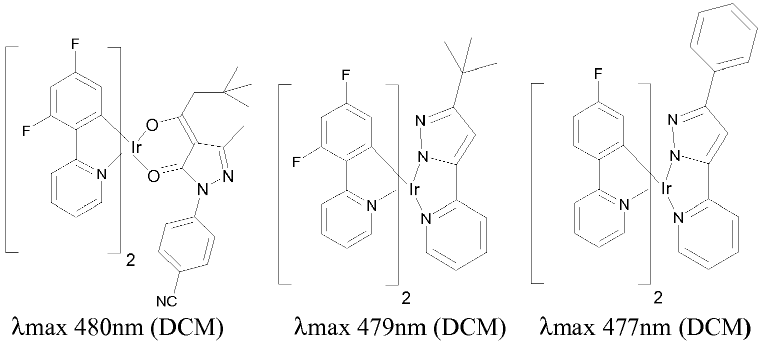

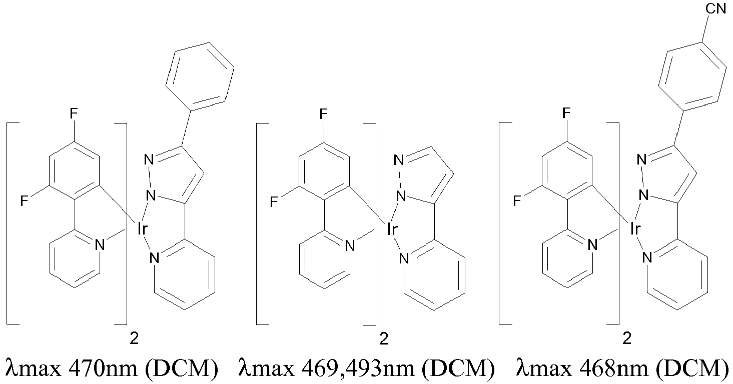

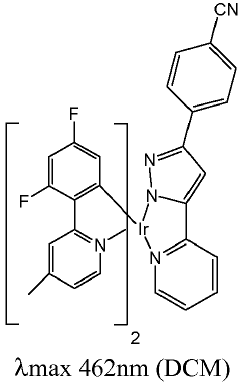

Examples of green phosphorescent materials that may be employed with CBP or TAZ are set out below (see WO 2005/080526):

### Green Phosphorescent Materials

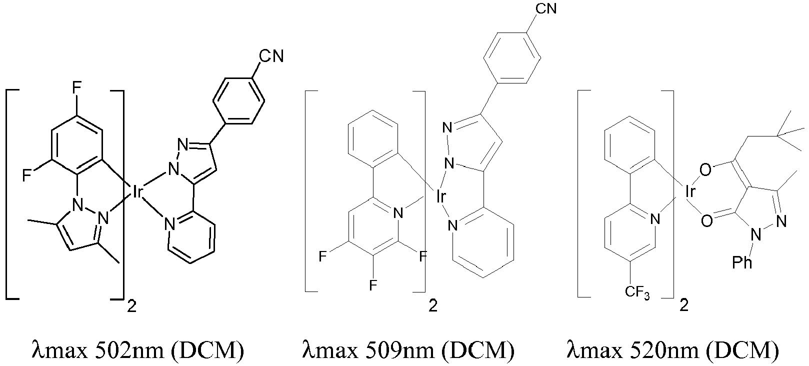

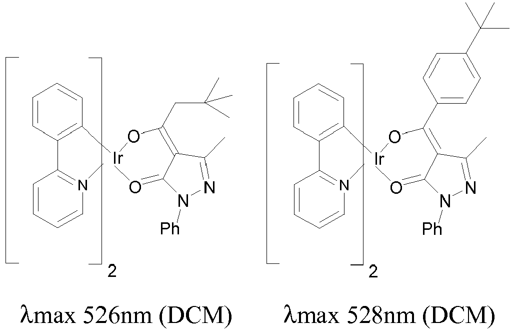

Examples of red phosphorescent materials that may be employed with CBP or TAZ are set out below (see WO 2005/080526):

### Red Phosphorescent Materials

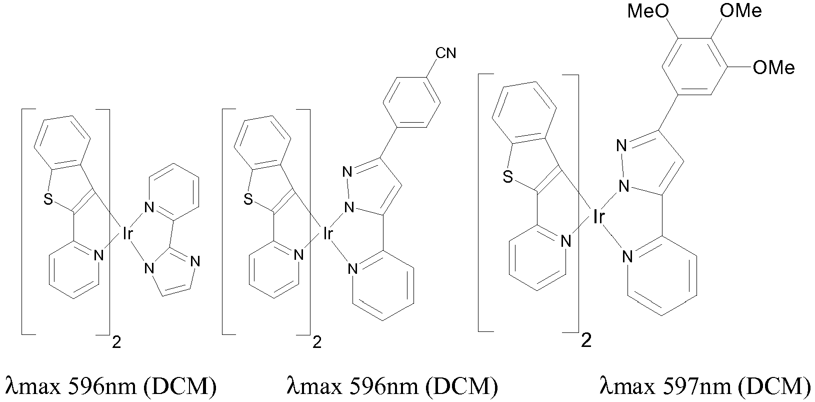

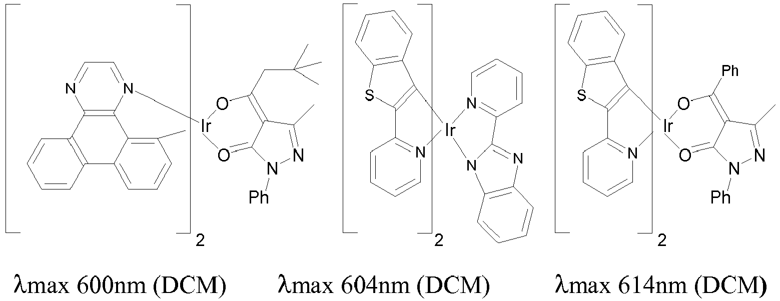

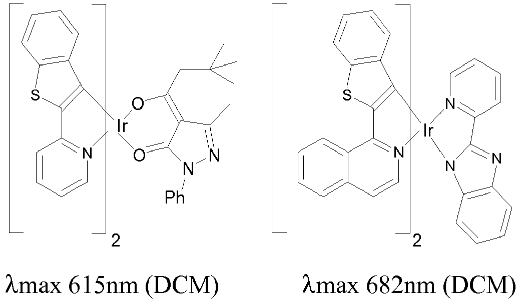

As further dopants, fluorescent laser dyes are recognized to be particularly useful fluorescent materials for use in the organic EL devices of this invention. Dopants which can be used include diphenylacridine, coumarins, perylene and their derivatives. Useful fluorescent dopants are disclosed in US 4769292. One class of preferred dopants is coumarins. The following are illustrative fluorescent coumarin dyes known to be useful as laser dyes:
FD-1 7-Diethylamino-4-methylcoumarin,
FD-2 4,6-Dimethyl-7-ethylaminocoumarin,
FD-3 4-Methylumbelliferone,
FD-4 3-(2'-Benzothiazolyl)-7-diethylaminocoumarin,
FD-5 3-(2'-Benzimidazolyl)-7-N,N-diethylaminocoumarin,
FD-6 7-Amino-3-phenylcoumarin,
FD-7 3-(2'-N-Methylbenzimidazolyl)-7-N,Ndiethylaminocoumarin,
FD-8 7-Diethylamino-4-trifluoromethylcoumarin,
FD-9 2,3,5,6-1H,4H-Tetrahydro-8-methylquinolazino[9,9a,1-gh]coumarin,
FD-10 Cyclopenta[c]julolindino[9,10-3]-11H-pyran-11-one,
FD-11 7-Amino-4-methylcoumarin,
FD-12 7-Dimethylaminocyclopenta[c]coumarin,
FD-13 7-Amino-4-trifluoromethylcoumarin,
FD-14 7-Dimethylamino-4-trifluoromethylcoumarin,
FD-15 1,2,4,5,3H,6H,10H-Tetrahydro-8-trifluoromethyl[1]benzopyrano[9,9a,1-gh]quinolizin-10-one,
FD-16 4-Methyl-7-(sulfomethylamino)coumarin sodium salt,
FD-17 7-Ethylamino-6-methyl-4-trifluoromethylcoumarin,
FD-18 7-Dimethylamino-4-methylcoumarin,
FD-19 1,2,4,5,3H,6H,10H-Tetrahydro-carbethoxy[1]benzopyrano[9,9a,1-gh]quinolizino-10-one,
FD-20 9-Acetyl-1,2,4,5,3H,6H,10H-tetrahydro[1]benzopyrano[9,9a,1-gh]quinolizino-10-one,
FD-21 9-Cyano-1,2,4,5,3H,6H,10H-tetrahydro[1]benzopyrano[9,9a,1-gh]quinolizino-10-one,
FD22 9-(t-Butoxycarbonyl)-1,2,4,5,3H,6H,10H-tetrahyro[1]-benzopyrano-[9,9a,1-gh]quinolizino-10-one,
FD-23 4-Methylpiperidino[3,2-g]coumarin,
FD-24 4-Trifluoromethylpiperidino[3,2-g]coumarin,
FD-25 9-Carboxy-1,2,4,5,3H,6H,10H-tetrahydro[1]benzopyrano[9,9a,1-gh]quinolizino-10-one,
FD-26 N-Ethyl-4-trifluoromethylpiperidino[3,2-g] coumarin.

Other dopants include salts of bis benzene sulphonic acid (require deposition by spin-coating rather than sublimation) such as 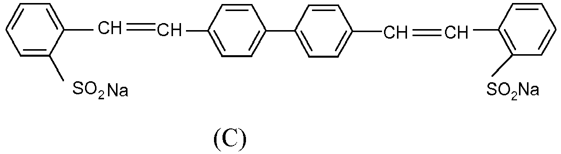 and perylene and perylene derivatives and dopants. Other dopants are dyes such as the fluorescent 4-dicyanomethylene-4H-pyrans and 4-dicyanomethylene-4H-thiopyrans, e.g. the fluorescent dicyanomethylenepyran and thiopyran dyes. Useful fluorescent dyes can also be selected from among known polymethine dyes, which include the cyanines, complex cyanines and merocyanines (i.e. tri-, tetra- and poly-nuclear cyanines and merocyanines), oxonols, hemioxonols, styryls, merostyryls, and streptocyanines. The cyanine dyes include, joined by a methine linkage, two basic heterocyclic nuclei, such as azolium or azinium nuclei, for example, those derived from pyridinium, quinolinium, isoquinolinium, oxazolium, thiazolium, selenazolium, indazolium, pyrazolium, pyrrolium, indolium, 3H-indolium, imidazolium, oxadiazolium, thiadioxazolium, benzoxazolium, benzothiazolium, benzoselenazolium, benzotellurazolium, benzimidazolium, 3H- or 1H-benzoindolium, naphthoxazolium, naphthothiazolium, naphthoselenazo lium, naphthotellurazo lium, carbazolium, pyrrolopyridinium, phenanthrothiazolium, and acenaphthothiazolium quaternary salts. Other useful classes of fluorescent dyes are 4-oxo-4H-benz-[d,e]anthracenes and pyrylium, thiapyrylium, selenapyrylium, and telluropyrylium dyes.

Further blue-emitting materials are disclosed m the following patents, applications and publications:
US-A-5141671 (Bryan, Kodak) - Aluminium chelates containing a phenolato ligand and two 8-quinolinolato ligands.

WO 00/32717 (Kathirgamanathan) - Lithium quinolate which is vacuum depositable, and other substituted quinolates of lithium where the substituents may be the same or different in the 2,3,4,5,6 and 7 positions and are selected from alky, alkoxy, aryl, aryloxy, sulphonic acids, esters, carboxylic acids, amino and amido groups or are aromatic, polycyclic or heterocyclic groups.

US 2006/0003089 (Kathirgamanathan) - Lithium quinolate made by reacting a lithium alkyl or alkoxide with 8-hydroxyquinoline in acetonitrile.

Misra, http://l,vv..rvv.ursi.org/Proceedings/ProcGA05/pdf/D04.5(01720).pdf Blue orgamc electroluminescent material bis-(2-methyl 8-quinolinolato) (triphenyl siloxy)aluminium (III) vacuum depositable at 1 x 10-⁵ Torr.

WO 03/006573 (Kathirgamanathan et al) - Metal pyrazolones.

WO 2004/084325 (Kathirgamanathan et al*) -* Boron complexes.

WO 2005/080526 (Kathitgamanathan et al*) -* Blue phosphorescent iridium-based complexes.

Ma et al., Chem. Comm. 1998, 2491-2492 Preparation and crystal structure of a tetranuclear zinc(II) compound [ZO(AID)₆] with 7-azaindolate as a bridging ligand. Fabrication of inter alia a single-layer LED by vacuum deposition of this compound (<200 °C, 2 x 10-⁶ Torr) onto a glass substrate coated with indium-tin oxide to form a thin homogeneous film was reported.

Further electroluminescent materials which can be used include metal quinolates such as aluminium quinolate, lithium quinolate, titanium quinolate, zirconium quinolate, hafnium quinolate etc.

Many further electroluminescent materials that may be used arc disclosed in US-A-6524727, 6565995, WO 2004/050793 (pyrazolones), WO 2004/058783 (diiridium metal complexes), WO 2006/016193 (dibenzothiophenyl metal complexes) and WO 2006/024878 (thianthrene metal complexes), see also WO 2006/ 040593. Rare earth chelates, in particular may be employed as green and red emitters and in some embodiments blue emitters. Furthermore, there may be used as electroluminescent materials conducting polymers e.g. polyaniline, phenylene vinylene polymers, fluorene homopolymers and copolymers, phenylene polymers, as indicated below:

### Conducting Polymers

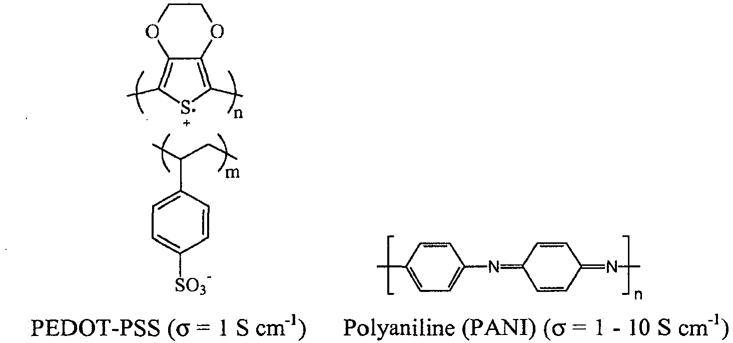

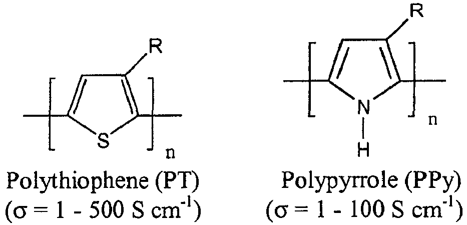

Mixed host materials have also been disclosed in the literature and may be used in OLEDs devices according to the invention. Various references disclose additives and mixed hosts for OLED's in an attempt to further improve properties. Jarikov et al., J. Appl. Phys., 100, 014901 (2006) discloses flat and rigid polycyclic aromatic hydrocarbons (PAHs) as LEL additives e.g. perylene. Jarikov et al. further report J. Appl. Phys., 100, pp. 094907-094907-7 (2006) perylene derivatives as light-emitting-layer (LEL) additives in organic light-emitting diodes (OLEDs). These molecules readily form emissive aggregates when added to the LEL. Addition of these polycyclic aromatic hydrocarbons increases the half-life (t₅₀) of undoped and doped OLEDs by 30-150 times e.g. in an Alq₃+dibenzo[b,k]perylene mixed host. The authors yet further report in J. Appl. Phys., 102, 104908 (2007) a synergistic effect of a lifetime-extending light-emitting-layer (LEL) additive and improved electron injection and transport in organic light-emitting diodes (OLEDs). Di-(2-naphthyl)perylene (DNP) serves as a LEL additive said to extend the operating lifetime of OLEDs by over two orders of magnitude. Using 2-phenyl-9,10-di(2-naphthyl)anthracene (PADN) as an electron-transport layer (ETL) and a separate layer of 4,7-diphenyl-1,10-phenanthroline (BPhen) as an electron-injection layer (EIL) the authors claimed to have significantly improved electron delivery into the charge recombination zone relative to traditional ETL made of tris(8-quinolinolate)aluminium (Alq). See also US-A-7175922 (Jarikov et al). J.C. Deaton et al *(supra)* disclose an a-NBP host with a "blue" aluminium quinolate as co-host and an iridium dopant. Very good yields were obtained with low concentrations of dopant for phosphorescent devices and it was found that the mixed host device provided increased power efficiency. It was hypothesized that the explanation was a reduction in the energy barrier to inject holes into the emissive layer by mixing the hole-transporting NPB having an ionization potential of 5.40 eV into the dominantly electron-transporting "blue" aluminium quinolate, having a higher ionization potential of 6.02 eV.

US-A-6392250 (Aziz et al) discloses organic light emitting devices comprising a mixed region comprising a mixture of a hole transport material e.g. an aromatic tertiary amine, an electron transport material e.g. a quinolate and a dopant material. For example N,N'-di-1-naphthyl-N,N'-diphenyl-1, 1'-biphenyl-1,1'-biphenyl-4,4'-diamine (NPB), and tris (8-hydroxyquinoline) aluminium (Alq₃) may be used as the hole transport material and the electron transport material, respectively and N,N'-dimethylquinacridone (DMQ), 5,6,11,12-tetraphenylnapthacene (Rubrene), and Nile-red dye (available from Aldrich Chemicals of Milwaukee, Wis.) may be used as dopants.

US 2002/0074935 (Kwong et al*)* also discloses devices with an emissive layer containing PtOEP or bis(benzothienyl-pyridinato-NAC)Iridium(III) (acetylacetonate) as a dopant and equal proportions ofNPB and Alq as host materials. It is explained that the mixed host electroluminescent mixed layer serves to substantially reduce the accumulation of charge that is normally present at the heterojunction interface of heterostructure devices, thereby reducing organic material decomposition and enhancing device stability and efficiency.

In US 2004/0155238 (Thompson et al.*)* a light emitting layer of the OLED device contains a wide band gap inert host matrix in combination with a charge carrying material and a phosphorescent emitter. The charge carrying compound can transport holes or electrons, and it is selected so that charge carrying material and phosphorescent emitter transport charges of opposite polarity.

M. Furugori et al. in US 2003/0141809 disclose phosphorescent devices where a host material is mixed with another hole- or electron transporting material in the light emitting layer. The document discloses that devices utilizing plural host compounds show higher current and higher efficiencies at a given voltage.

T. Igarashi et al. in WO 2004/062324 disclose phosphorescent devices with the light emitting layer containing at least one electron transporting compound, at least one hole transporting compound and a phosphorescent dopant.

WO 2006/076092 (Kondakova et al.) discloses OLED device comprising a cathode, an anode, and located therebetween a light emitting layer (LEL) comprising at least one hole transporting co-host e.g. an aromatic tertiary amine such as 4,4'-Bis[N-(1-naphthyl)-N-phenylamino]biphenyl (NPB), 4,4'-Bis[N-(1-naphthyl)-N-(2-naphthyl)amino]biphenyl (TNB), 4,4'-Bis[N-(3-methylphenyl)-N-phenylamino-]bi phenyl (TPD), 4,4'-Bis-diphenylamino-terphenyl or 2,6,2',6'-tetramethyl-N,N,N',N' -tetraphenyl-benzidine.and at least one electron transporting co-host e.g. a substituted 1,2,4-triazole such as 3-phenyl-4-(1-naphtyl)-5-phenyl-1,2,4-triazole or a substituted 1,3,5-triazine such as 2,4,6-tris(diphenylamino)-1,3,5-triazine, 2,4,6-tricarbazolo-1,3 ,5-triazine, 2,4,6-tris(N-phenyl-2-naphthylamino)-1,3,5-triazine, 2,4,6-tris(N-phenyl-1-naphthylamino)-1,3,5-triazine and 4,4',6,6'-tetraphenyl-2,2'-bi-1,3,5-triazine together with a phosphorescent emitter, wherein the triplet energy of each of the co-host materials is greater than the triplet energy of the phosphorescent emitter, and further containing an exciton blocking layer comprising a hole transporting material with triplet energy greater or equal to 2.5 eV adjacent the emitting layer on the anode side, which may be a substituted triarylamine e.g. 4,4',4"-tris[(3-methylphenyl)phenylamino]triphenylamine (MTDATA), 4,4',4"-tris(N,N-diphenyl-amino)triphenylamine (TDATA), N,N-bis[2,5-dimethyl-4-[(3-methylphenyl)-phenylamino]phenyl]-2,5-dimethyl-N'-(3-methylphenyl)-N'-phenyl-1,4-benzenediamine. The devices are said to exhibit improved efficiency and reduced drive voltage.

US-A-7045952 (Lu, Universal Display Corporation) discloses an organic light emissive device comprising an emissive region disposed between and electrically connected to an anode and a cathode, wherein the emissive region comprises (i) a first single-host emissive layer, comprising a first host material, and (ii) a mixed-host emissive layer in direct contact with the first single-host emissive layer, wherein the mixed-host emissive layer comprises the first host material, and a second host material, and wherein the first single-host emissive layer and the mixed-host emissive layer each further comprise a phosphorescent emissive material.

### Electron Transport material

Known electron transport materials may be used, including, for example, quinolates.

Aluminium quinolate is thermally and morphologically stable to be evaporated into thin films, easily synthesized and purified and is widely used despite its problems of relatively low mobility, bandgap and tendency to ashing during sublimation. As disclosed in patent application GB 0625541.8 filed 22 December 2006, imporived electron transport materials consist of or comprise zirconium or hafnium quinolate, zirconium quinolate being preferred for many embodiments.

Zirconium quinolate has a particularly advantageous combination of properties for use as an electron transport material and which identify it as being a significant improvement on aluminium quinolate for use as an electron transport material. It has high electron mobility. Its melting point (388°C) is lower than that of aluminium quinolate (414°C). It can be purified by sublimation and unlike aluminium quinolate it resublimes without residue, so that it is even easier to use than aluminium quinolate. Its lowest unoccupied molecular orbital (LUMO) is at - 2.9 eV and its highest occupied molecular orbital (HOMO) is at - 5.6 eV, similar to the values of aluminium quinolate. Furthermore, unexpectedly, it has been found that when incorporated into a charge transport layer it slows loss of luminance of an OLED device at a given current with increase of the time for which the device has been operative (i.e. increases device lifetime), or increases the light output for a given applied voltage, the current efficiency for a given luminance and/or the power efficiency for a given luminance. Embodiments of cells in which the electron transport material is zirconium quinolate can exhibit reduced tum-on voltage and up to four times the lifetime of similar cells in which the electron transport material is zirconium quinolate. It is compatible with aluminium quinolate when aluminium quinolate is used as host in the electroluminescent layer of an OLED, and can therefore be employed by many OLED manufacturers with only small changes to their technology and equipment. It also forms a good electrical and mechanical interface with inorganic electron injection layers e.g. a LiF layer where there is a low likelihood of failure by delamination. Of course zirconium quinolate can be used both as host in the electroluminescent layer and as electron transfer layer. The properties of hafnium quinolate are generally similar to those of zirconium quinolate.

Zirconium or hafnium quinolate may be the totality, or substantially the totality of the electron transport layer. It may be a mixture of co-deposited materials which is predominantly zirconium quinolate. The zirconium or hafnium may be doped as described m WO 2008/012584 Kathorgamanathan et al., application No. PCT/GB2007/050451). Suitable dopants include fluorescent or phosphorescent dyes or ion fluorescent materials e.g. as described above in relation to the electroluminescent layer, e.g. in amounts of 0.01-25 wt% based on the weight of the doped mixture. Other dopants include metals which can provide high brightness at low voltage. Additionally or alternatively, the zirconium or hafnium quinolate may be used in admixture with another electron transport material. Such materials may include complexes of metals in the trivalent or pentavalent state which should further increase electron mobility and hence conductivity. The zirconium and hafnium quinolate may be mixed with a quinolate of a metal of group 1, 2, 3, 13 or 14 of the periodic table, e.g. lithium quinolate or zinc quinolate. Preferably the zirconium or hafnium quinolate comprises at least 30 wt% of the electron transport layer, more preferably at least 50 wt%.

### Electron injection material

The electron injection layer is deposited direct onto the cathode.

An electron injection layer deposited direct onto the cathode comprises a compound of the formula 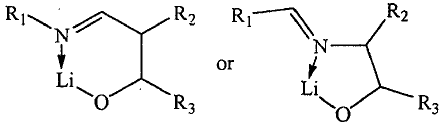 wherein
R₁ is a 1-5 ring aryl (including polycyclic aryl or aryl-substituted polycyclic aryl), aralkyl or heteroaryl group which may be substituted with one or more C₁-C₄ alkyl or alkoxy substituents; and
R₂ and R₃ together form a 1-5 ring aryl (including polycyclic or aryl-substituted polycyclic aryl), aralkyl or heteroaryl group which may be substituted with one or more C₁-C₄ alkyl or alkoxy substituents. A compound of the above formula may be used alone or in combination with another electron injection material e.g. a quinolate such as lithium or zirconium quinolate. The Schiff base preferably comprises at least 30 wt% of the electron injection layer, more preferably at least 50 wt%.

In the formula set out above, R₁ may be polycyclic aryl e.g. naphthyl, anthracenyl, tetracenyl, pentacenyl or a perylene or pyrene compound or may have up to 5 aromatic rings arranged in a chain e.g. biphenyl. It is preferably phenyl or substituted phenyl. R₂ and R₃ together may form the same groups as R₁ and are preferably phenyl or substituted phenyl. Where substituents are present they may be methyl, ethyl, propyl or butyl, including t-butyl substituted, or may be methoxy, ethoxy, propoxy or butoxy including t-butoxy substituted. Particular compounds include

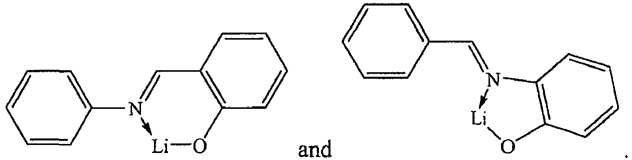

Lithium compounds whose formulae are set out above are believed from MS measurements to be capable of forming cluster compounds or oligomers in which 2-8 molecules of formula as set out above are associated e.g. in the form of trimeric, tetrameric, hexameric or octomeric oligomers. It is believed that such lithium compounds may in some embodiments associate in trimeric units having a core structure which has alternating Li and O atoms in a 6-membered ring, and that these trimeric units may further associate in pairs. The existence of such structures in lithium quinolate has been detected by crystallography, see Begley *et al.,* Hexakis(µ-quinolin-8-olato)hexalithium (I): a centrosymmetric doubly stacked trimer, Acta Cryst. (2006), **E62,** m1200-m1202. It is also believed that formation of oligomeric structures of this type imparts a greater covalent character to the Li-O bonds which may be responsible for the volatility of many of the compounds of the invention which enables them to be deposited at relatively low temperatures by vacuum sublimation. However, other structures may also be possible e.g. cubic structures.

### Cathode

In many embodiments, aluminium is used as the cathode either on its own or alloyed with elements such as magnesium or silver, although in some embodiments other cathode materials e.g. calcium may be employed. In an embodiment the cathode may comprise a first layer of alloy e.g. Li-Ag, Mg-Ag or Al-Mg closer to the electron injection or electron transport layer and a second layer of pure aluminium further from the electron injection or electron transport layer. Cathode materials may also be on transparent plate materials which are of plastics which may be rigid or flexible and may be optically transparent As regards plastics substrates, rigid or flexible transparent plastics materials may be used, preferably materials which are dimensionally stable, impermeable to water (including water vapour) of relatively high Tg. PEN is a preferred material, other materials that may be used including PES, PEEK and PET. The plastics are coated according to claim 1 to improve resistance to moisture which may be encountered under working conditions e.g. atmospheric moisture.

In the case of a reverse OLED, the substrate may be e.g. PEN film or sheet on which are one or more barrier layers, a low work function metal and electron injection material as described above. Low work function metals include aluminium, barium, calcium, lithium, rare earth metals, transition metals, magnesium and alloys thereof such as silver/magnesium alloys, rare earth metal alloys etc; aluminium is a preferred metal. The metal electrode may consist of a plurality of metal layers; for example a higher work function metal such as aluminium deposited on the substrate and a lower work function metal such as calcium deposited on the higher work function metal. The work function of some metals are listed below in Table 1.

**Table 1**

| Metal | Work Function eV* |
|---|---|
| Li | 2.9 |
| Na | 2.4 |
| K | 2.3 |
| Cs | 1.9 |
| Ba | 2.5 |
| Ca | 2.9 |
| Nb | 2.3 |
| Zr | 4.05 |
| Mg | 3.66 |
| Al | 4.2 |
| Cu | 4.6 |
| Ag | 4.64 |
| Zn | 3.6 |
| Sc | 3.5 |

| | |
|---|---|
| * Handbook of Chemistry and Physics | |

The layer of e.g. the metal quinolate is preferably about 0.3 nm in thickness and preferably has a work function of less than magnesium 3.7 eV, this being regarded for present purposes as a low work function.

In many embodiments, aluminium is used as the cathode either on its own or alloyed with elements such as magnesium or silver, although in some embodiments other cathode materials e.g. calcium, may be employed. In an embodiment the cathode may comprise a first layer of alloy e.g. Li-Ag, Mg-Ag or Al-Mg closer to the electron injection or electron transport layer and a second layer of pure aluminium further from the electron injection or electron transport layer. In further embodiments the cathode material may be Ag or MgAg or Mgin. Cathode materials are on transparent plate materials which are of plastics which may be rigid or flexible and may be optically transparent As regards plastics substrates, rigid or flexible.
transparent plastics materials may be used, preferably materials which are dimensionally stable, impermeable to water (including water vapour) of relatively high Tg. PEN is a preferred material, other materials that may be used including PES, PEEK and PET.

## Claims

1. A plastics cathode substrate for an electro-optical device, said substrate having
(a) a barrier layer or stacked barrier layers on a surface thereof providing a moisture and/or oxygen barrier, wherein the thickness of the barrier layer(s) is in the range from 10 nm to 1 µm and
(b) a metal layer of a low work function metal selected from Li-Ag, MgAg, AlMg, aluminium, barium, calcium, lithium, rare earth metals, transition metals, magnesium and alloys thereof and characterized that it has thereon
(c) an electron injection layer comprising a compound of the formula 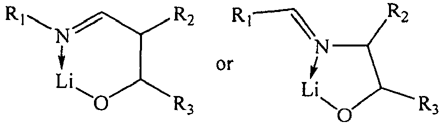 wherein
R₁ is a 1-5 ring aryl (including polycyclic aryl or aryl-substituted polycyclic aryl), aralkyl or heteroaryl group which may be substituted with one or more C₁₋C₄ alkyl or alkoxy substituents; and
R₂ and R₃ together form a 1-5 ring aryl (including polycyclic or aryl-substituted polycyclic aryl), aralkyl or heteroaryl group which may be substituted with one or more C₁-C₄ alkyl or alkoxy substituents.

2. The substrate of claim 1, which is a film or sheet.

3. The substrate of claim 1 or 2, which is of polyethylene terephthalate (PET), polyethylene naphthalate (PEN), polybutylene terephthalate (PBT) or other polyester, polyether sulfone (PES) or polyether ether ketone (PEEK).

4. The substrate of claim 1, 2 or 3, having a barrier layer of poly-*p*-xylene, poly(2-chloro-1,4-dimethylbenzene) or poly(1,4-dichloro-2,5-dimethylbenzene).

5. The substrate of any preceding claim, having a barrier layer of a metal, metal oxide or nitride.

6. The substrate of any preceding claims, wherein the metal layer of a low work function metal is an aluminum layer.

7. The substrate of any preceding claims, having an electron injection layer comprising

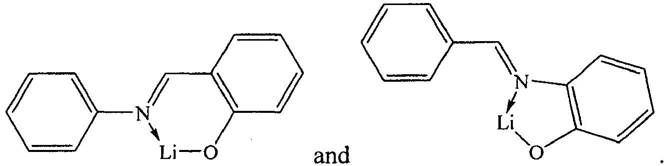

8. An OLED having a cathode layer **characterized in that** the cathode layer comprises the substrate as claimed in any preceding claim.

9. A method for forming an OLED comprising a compound of the formula 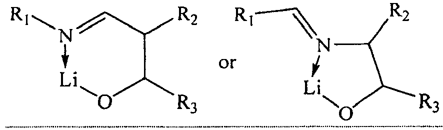 as described in claim 1, which comprises:
providing a plastics substrate;
depositing one or more metallic or inorganic barrier layers on the substrate by means of plasma assisted CVD, atomic layer epitaxy (ALE), atomic layer deposition (ALD) or atomic layer CVD;
depositing one or more organic barrier layers on the metallic or inorganic layers; depositing an electron injection layer onto the barrier layer or stacked barrier layers and the metal layer as described in claim 1 and
depositing OLED-forming layers on the barrier layers.

10. The method of claim 9, wherein the inorganic barrier layer or layers comprise Al₂O₃, CaO, amorphous TiOₓ, TiO₂, Zr₂O₅, Hf₂O₅, Ta₂O₅, or Nb₂O₅ or SiO₂ or SiOₓ or an oxide of scandium, yttrium, lanthanum, vanadium, molybdenum , tungsten, silicon, zinc and indium or a mixed metal oxide.

11. The method of claim 9 or 10, wherein the organic barrier layer comprises poly-*p*-xylene, poly(2-chloro-1,4-dimethylbenzene) or poly(1,4-dichloro-2,5-dimethylbenzene).

## Patentansprüche

1. Kathodensubstrat aus Kunststoff für eine elektrooptische Vorrichtung, wobei das Substrat Folgendes aufweist
(a) eine Barriereschicht oder gestapelte Barriereschichten auf einer Oberfläche davon, die eine Feuchtigkeits- und/oder Sauerstoffbarriere bereitstellt/bereitstellen, wobei die Dicke der Barriereschicht(en) im Bereich von 10 nm bis 1 µm liegt und
(b) eine Metallschicht aus einem Metall mit geringer Austrittsarbeit, das aus Li-Ag, MgAg, AlMg, Aluminium, Barium, Calcium, Lithium, Seltenerdmetallen, Übergangsmetallen, Magnesium und Legierungen davon ausgewählt ist, und **dadurch gekennzeichnet, dass** es darauf
(c) eine Elektroneninjektionsschicht enthaltend eine Verbindung der Formel 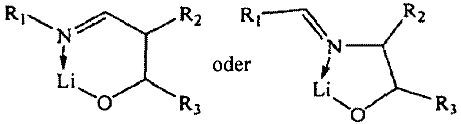 aufweist, worin
R₁ eine 1-5-Ring-Aryl- (einschließlich polycyclisches Aryl oder arylsubstituiertes polycyclisches Aryl), Aralkyl- oder Heteroarylgruppe ist, die mit einem oder mehreren C₁-C₄-Alkyl- oder -Alkoxysubstituenten substituiert sein kann; und
R₂ und R₃ zusammen eine 1-5-Ring-Aryl- (einschließlich polycyclisches oder arylsubstituiertes polycyclisches Aryl), Aralkyl- oder Heteroarylgruppe bilden, die mit einem oder mehreren C₁-C₄-Alkyl- oder -Alkoxysubstituenten substituiert sein kann.

2. Substrat des Anspruchs 1, bei dem es sich um einen Film oder eine Folie handelt.

3. Substrat des Anspruchs 1 oder 2, das aus Polyethylenterephthalat (PET), Polyethylennaphthalat (PEN), Polybutylenterephthalat (PBT) oder anderem Polyester, Polyethersulfon (PES) oder Polyetheretherketon (PEEK) ist.

4. Substrat des Anspruchs 1, 2 oder 3, mit einer Barriereschicht aus Poly-*p*-xylol, Poly(2-chlor-1,4-dimethylbenzol) oder Poly(1,4-dichlor-2,5-dimethylbenzol).

5. Substrat beliebigen vorhergehenden Anspruchs, mit einer Barriereschicht aus einem Metall, Metalloxid oder Nitrid.

6. Substrat beliebiger vorhergehender Ansprüche, bei dem es sich bei der Metallschicht aus einem Metall mit geringer Austrittsarbeit um eine Aluminiumschicht handelt.

7. Substrat beliebiger vorhergehender Ansprüche, mit einer Elektroneninjektionsschicht enthaltend

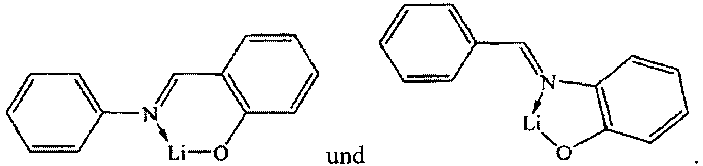

8. OLED mit einer Kathodenschicht, **dadurch gekennzeichnet, dass** die Kathodenschicht das Substrat wie in einem beliebigen vorhergehenden Anspruch beansprucht enthält.

9. Verfahren zur Bildung einer OLED enthaltend eine Verbindung der Formel 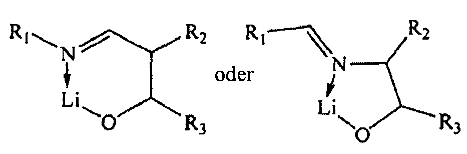 wie in Anspruch 1 beschrieben, das umfasst:
Bereitstellen eines Kunststoffsubstrates;
Abscheiden von einer oder mehreren metallischen oder anorganischen Barriereschichten auf dem Substrat mittels plasmaunterstützter CVD, Atomlagenepitaxie (ALE), Atomlagenabscheidung (atomic layer deposition - ALD) oder Atomlagen-CVD;
Abscheiden von einer oder mehreren organischen Barriereschichten auf den metallischen oder anorganischen Schichten;
Abscheiden einer Elektroneninjektionsschicht auf der Barriereschicht oder den gestapelten Barriereschichten und der Metallschicht wie in Anspruch 1 beschrieben und Abscheiden OLED-bildender Schichten auf den Barriereschichten.

10. Verfahren des Anspruchs 9, bei dem die anorganische Barriereschicht oder -schichten Al₂O₃, CaO, amorphes TiOₓ, TiO₂, Zr₂O₅, Hf₂O₅, Ta₂O₅ oder Nb₂O₅ oder SiO₂ oder SiOₓ oder ein Oxid des Scandiums, Yttriums, Lanthans, Vanadiums, Molybdäns, Wolframs, Siliziums, Zinks und Indiums oder eine Mischmetalloxid enthalten.

11. Verfahren des Anspruchs 9 oder 10, bei dem die organische Barriereschicht Poly-*p-*xylol, Poly(2-chlor-1,4-dimethylbenzol) oder Poly(1,4-dichlor-2,5-dimethylbenzol) enthält.

## Revendications

1. Substrat de cathode en matière plastique pour un dispositif électro-optique, ledit substrat comportant :
(a) une couche de barrière ou des couches de barrière empilées sur une surface de celui-ci, laquelle ou lesquelles couche(s) constitue(nt) une barrière vis-à-vis de l'humidité et/ou de l'oxygène, dans lequel l'épaisseur de la/des couche(s) de barrière est dans la plage qui va de 10 nm à 1 µm ; et
(b) une couche en métal réalisée en un métal présentant un potentiel d'extraction faible qui est sélectionné parmi le Li-Ag, le MgAg, l'AlMg, l'aluminium, le baryum, le calcium, le lithium, les métaux des terres rares, les métaux de transition, le magnésium et leurs alliages, et **caractérisé en ce qu'**il comporte sur lui :
(c) une couche d'injection d'électrons qui comprend un composé de la formule : 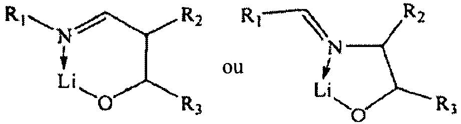 dans laquelle :
R₁ est un groupe aryle à 1 à 5 cycle(s) (incluant aryle polycyclique ou aryle polycyclique à substitution d'aryle), aralkyle ou hétéroaryle, lequel groupe peut être substitué par un ou plusieurs substituant(s) C₁-C₄ alkyle ou alcoxy ; et
R₂ et R₃ forment en association un groupe aryle à 1 à 5 cycle(s) (incluant aryle polycyclique ou aryle polycyclique à substitution d'aryle), aralkyle ou hétéroaryle, lequel groupe peut être substitué par un ou plusieurs substituant(s) C₁-C₄ alkyle ou alcoxy.

2. Substrat selon la revendication 1, lequel est un film ou une feuille.

3. Substrat selon la revendication 1 ou 2, lequel est en téréphtalate de polyéthylène (PET), en naphtalate de polyéthylène (PEN), en téréphtalate de polybutylène (PBT) ou en un autre polyester, en polyéthersulfone (PES) ou en polyétheréthercétone (PEEK).

4. Substrat selon la revendication 1, 2 ou 3, comportant une couche de barrière en poly-*p*-xylène, en poly(2-chloro-1,4-diméthylbenzène) ou en poly(1,4-dichloro-2,5-diméthylbenzène).

5. Substrat selon l'une quelconque des revendications précédentes, comportant une couche de barrière en un métal, en un oxyde de métal ou en un nitrure de métal.

6. Substrat selon l'une quelconque des revendications précédentes, dans lequel la couche en métal réalisée en un métal d'un potentiel de travail faible est une couche en aluminium.

7. Substrat selon l'une quelconque des revendications précédentes, comportant une couche d'injection d'électrons comprenant :

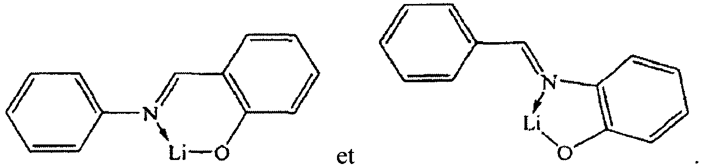

8. OLED comportant une couche de cathode, **caractérisée en ce que** la couche de cathode comprend le substrat tel que revendiqué selon l'une quelconque des revendications précédentes.

9. Procédé pour former une OLED comprenant un composé de la formule : 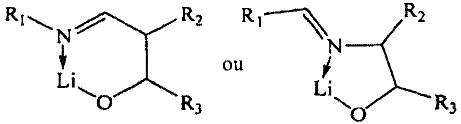 comme décrit selon la revendication 1, lequel procédé comprend :
la fourniture d'un substrat en matière plastique ;
le dépôt d'une ou de plusieurs couche(s) de barrière métallique(s) ou inorganique(s) sur le substrat au moyen d'un procédé de dépôt chimique en phase vapeur (CVD) assisté plasma, d'une épitaxie par couche atomique (ALE), d'un dépôt de couches atomiques (ALD) ou d'un procédé CVD par couche atomique ;
le dépôt d'une ou de plusieurs couche(s) de barrière organique(s) sur les couches métalliques ou inorganiques ;
le dépôt d'une couche d'injection d'électrons sur la couche de barrière ou sur les couches de barrière empilées et la couche en métal comme décrit selon la revendication 1 ; et
le dépôt de couches de formation d'OLED sur les couches de barrière.

10. Procédé selon la revendication 9, dans lequel la couche ou les couches de barrière inorganique(s) comprend/comprennent de l'Al₂O₃, du CaO, du TiOₓ amorphe, du TiO₂, du Zr₂O₅, du Hf₂O₅, du Ta₂O₅ ou du Nb₂O₅ ou du SiO₂ ou du SiOₓ ou un oxyde de scandium, d'yttrium, de lanthane, de vanadium, de molybdène, de tungstène, de silicium, de zinc et d'indium ou un oxyde métallique mélangé.

11. Procédé selon la revendication 9 ou 10, dans lequel la couche de barrière organique comprend du poly-*p*-xylène, du poly(2-chloro-1,4-diméthylbenzène) ou du poly(1,4-dichloro-2,5-diméthylbenzène).
